# FASCICULE DE BREVET EUROPEEN

(11) **EP 0 466 594 B1**
(45) Date de publication et mention de la délivrance du brevet: **15.03.1995**
(21) Numéro de dépôt: 91401933.6
(22) Date de dépôt: 10.07.1991
(51) Int. Cl.: G01R 31/28, H02H 7/125

(54) **Dispositif de surveillance pour redresseur polyphasé**
Vorrichtung zur Überwachung eines Mehrphasen-Gleichrichters
Device for monitoring a polyphase rectifier

(30) Priorité: 11.07.1990 FR 9008822
(43) Date de publication de la demande: 15.01.1992
(73) Titulaire: SEXTANT AVIONIQUE S.A., F-92366 Meudon la Forêt Cédex (FR)
(72) Inventeur: Bocquet, Benoît, F-75015 Paris (FR); Hetyei, Joseph, F-95570 Bouffemont (FR); Langlois, Patrick, F-93150 Le Blanc-Mesnil (FR)
(74) Mandataire: Bloch, Gérard

(56) Documents cités:
- EP-A- 0 286 951
- DE-A- 2 460 773
- GB-A- 2 029 138
- US-A- 4 380 045

## Description

La présente invention a pour objet un dispositif de surveillance pour redresseur polyphasé.

Un tel dispositif trouve notamment son application pour les transformateurs-redresseurs de forte puissance.

Un tel transformateur-redresseur comprend par exemple un primaire triphasé, chacun des trois enroulements de ce primaire recevant une tension de fréquence 400 Hz. Le secondaire du transformateur comprend six enroulements dont trois sont montés en triangle et trois sont montés en étoile. Il est prévu, pour chacun des six enroulements secondaires, un redressement double alternance, qui met donc en oeuvre douze diodes. La tension continue en sortie du redresseur, destinée à charger des batteries et/ou à alimenter des équipements, présente une ondulation résiduelle de faible amplitude, et dont la fréquence est, dans l'exemple décrit, égale à douze fois la fréquence du réseau relié au primaire. Dans le cas où la fréquence du réseau est de 400 Hz, la fréquence de l'ondulation est donc de 4800 Hz.

Dans un transformateur-redresseur, il est important d'éviter les pannes et en particulier les pannes qui ont pour conséquence la destruction du transformateur-redresseur. Ceci est particulièrement important lorsque le redresseur est utilisé à bord d'un aéronef, ou toute panne peut avoir des conséquences graves, et où les critères relatifs à la surveillance sont particulièrement sévères.

On connaît déjà, par le document GB-A-2 029 138 un dispositif de surveillance pour redresseur polyphasé comprenant des moyens de détection de la mise en circuit ouvert d'au moins une des diodes de redressement dont est pourvu le redresseur, pour commander une alarme en cas de détection.

Un tel dispositif de surveillance est efficace car, dans un redresseur , de nombreuses pannes ont pour origine la mise en circuit ouvert d'une des diodes de redressement. Or, en l'absence d'un dispositif de surveillance, une telle panne reste cachée, car, vu de l'extérieur, le redresseur continue de fonctionner apparemment sans défaut. En effet, la seule conséquence de la panne que constitue la mise en circuit ouvert d'une diode est une réduction du courant maximal susceptible d'être fourni par le redresseur, réduction qui n'est pas décelée si le courant effectivement fourni est inférieur à cette valeur maximale.

Toutefois, les diodes restantes doivent fournir le courant demandé par l'utilisation, et de ce fait leur surcharge augmente proportionnellement au fur et à mesure que d'autres diodes tombent en panne en se mettant en circuit ouvert. Cette surcharge peut devenir destructive si le courant demandé par l'utilisation dépasse la capacité en débit des diodes restantes.

Le dispositif de surveillance décrit ci-dessus évite ce type de problème, puisque l'utilisateur est averti par l'alarme dès qu'une diode se met en circuit ouvert, ce qui permet de prendre des mesures préventives, par exemple en prévoyant une intervention pour changer la diode en panne lors de la prochaine période de repos du redresseur, ou encore en remplaçant immédiatement le redresseur en service par un redresseur de rechange, si les contraintes de sécurité sont particulièrement sévères.

Le dispositif de l'art antérieur comporte toutefois deux sérieux inconvénients.

Tout d'abord, il est très complexe, et donc coûteux et peu fiable.

On y compare en effet la tension de sortie du pont redresseur surveillé à la tension de sortie d'un pont comparateur, lui-même similaire au pont redresseur surveillé, et donc soumis aux mêmes aléas que ce dernier. En cas de défaillance constatée, on est par conséquent dans l'incapacité de savoir si elle provient du système surveillé ou du système de surveillance.

Par ailleurs, rien ne permet, dans le dispositif antérieur, d'adapter la comparaison en fonction de la charge du pont redresseur surveillé.

La présente invention vise à pallier ces inconvénients.

A cet effet, l'invention a pour objet un dispositif du type précité, caractérisé par le fait que lesdits moyens de détection détectent le franchissement temporaire d'un seuil bas par la tension en sortie dudit redresseur.

Le dispositif de l'invention est particulièrement léger, simple, fiable et d'un coût relativement bas, dans la mesure où la mise en circuit ouvert de l'une quelconque des diodes du pont redresseur est détectée à l'aide d'un seul circuit de surveillance des variations de la tension en sortie de ce redresseur. En effet, le dispositif de l'invention est basé sur le fait que l'allure de la composante alternative, ou ondulation résiduelle, en sortie du redresseur change lorsqu'une ou plusieurs diodes sont en circuit ouvert. Notamment, dès qu'il en est ainsi, l'ondulation de la tension de sortie présente des pointes descendantes qui se répètent avec la période de la tension primaire.

Avantageusement, il est prévu des moyens de commande de la valeur dudit seuil bas en réponse à la valeur du courant en sortie dudit redresseur, de façon à ce que la valeur dudit seuil bas diminue quand la valeur dudit courant augmente.

Dans ce cas le fonctionnement est sûr et sans fausses alarmes, car l'amplitude des pointes négatives de la tension de sortie augmente avec le courant de sortie. La valeur du seuil bas se trouve ainsi réglée de façon automatique pour une détection sûre quelle que soit la charge.

Avantageusement encore, il est prévu un circuit monostable, déclenché en réponse audit franchissement temporaire, et dont la constante de temps est supérieure à la période de la tension à redresser par ledit redresseur.

Ainsi d'éventuelles impulsions parasites ne se répétant pas avec la fréquence de la tension primaire ne sont pas prises en compte.

Avantageusement encore, il est prévu des moyens d'intégration de la valeur du signal de sortie dudit circuit monostable, et des moyens de comparaison, à un seuil haut, de la valeur du signal en sortie desdits moyens d'intégration, qui déclenchent ladite alarme en cas de franchissement dudit seuil haut par le signal en sortie desdits moyens d'intégration.

La protection contre les fausses alarmes s'en trouve encore améliorée.

La présente invention sera mieux comprise à la lecture de la description suivante de la forme de réalisation préférée du dispositif de surveillance de l'invention, faite en se référant aux dessins annexés, sur lesquels :
- la figure 1 représente un schéma d'un transformateur-redresseur pourvu du dispositif de surveillance de l'invention,
- les figures 2a, 2b et 2c représentent l'allure de la tension en sortie du transformateur-redresseur de la figure 1 dans les cas où le nombre de diodes en circuit ouvert est égal à zéro, une et deux respectivement,
- la figure 3 représente un schéma par blocs du dispositif de surveillance de la figure 1,
- les figures 4a à 4c représentent les diagrammes temporels de signaux illustrant le fonctionnement du dispositif de la figure 4, et,
- les figures 5a à 5d représentent les diagrammes temporels de signaux des figures 4 et d'autres signaux analogues, sur une durée supérieure à celle des diagrammes des figures 4.

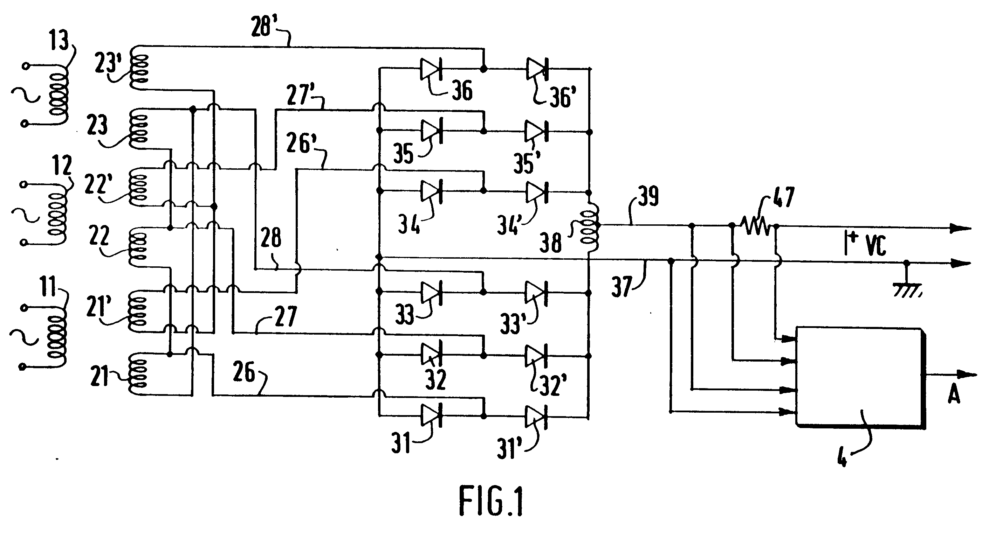

En se référant à la figure 1, un transformateur-redresseur est pourvu de trois enroulements 11, 12 et 13, recevant une tension triphasée, ici à 400 Hz, à redresser en vue de sa transformation en une tension continue VC destinée à alimenter les équipements et à charger les batteries d'un aéronef, par exemple.

A cet effet, il est prévu six enroulements secondaires 21, 21′, 22, 22′, 23 et 23′ couplés aux enroulements primaires 11, 12 et 13.

Les trois enroulements secondaires 21, 22 et 23 sont, de façon connue, montés en "triangle", chacun des points communs à deux de ces enroulements étant désignés par les références 26, 27 et 28 respectivement.

Les trois enroulements secondaires 21′, 22′ et 23′ sont, de façon connue, montés en "étoile", chacune des extrémités libres de ces enroulements étant désignés par les références 26′, 27′ et 28′.

Un pont redresseur comprend ici douze diodes 31, 31′, 32, 32′, 33, 33′, 34, 34′, 35, 35′, 36 et 36′. Les anodes des diodes 31, 32, 33, 34, 35 et 36 sont toutes reliées a même point commun 37. Les cathodes des diodes 31, 32, 33, 34, 35 et 36, reliées aux anodes des diodes 31′, 32′, 33′, 34′, 35′ et 36′ respectivement, sont également reliées aux points 26, 27, 28, 26′, 27′ et 28′ respectivement.

Les cathodes des diodes 31′, 32′ et 33′ sont reliées à une extrémité d'une bobine d'inductance 38. Les cathodes des diodes 34′, 35′ et 36′ sont reliées à l'autre extrémité de la bobine 38.

La tension redressée VC est disponible entre le point 37, relié ici à la masse, et le point milieu 39 de la bobine 38. Le point 39 est raccordé aux circuits d'utilisation de la tension redressée VC par l'intermédiaire d'une résistance 47 de très faible valeur.

Un circuit électronique 4 est pourvu d'une première entrée à laquelle est appliquée la tension VC, d'une deuxième entrée à laquelle est appliquée la tension aux bornes de la résistance 47, et d'une sortie délivrant un signal A de commande d'alarme, qui devient actif lorsque le circuit électronique 4, par analyse de la forme de l'ondulation de la tension redressée VC, a détecté la mise en circuit ouvert d'au moins une diode.

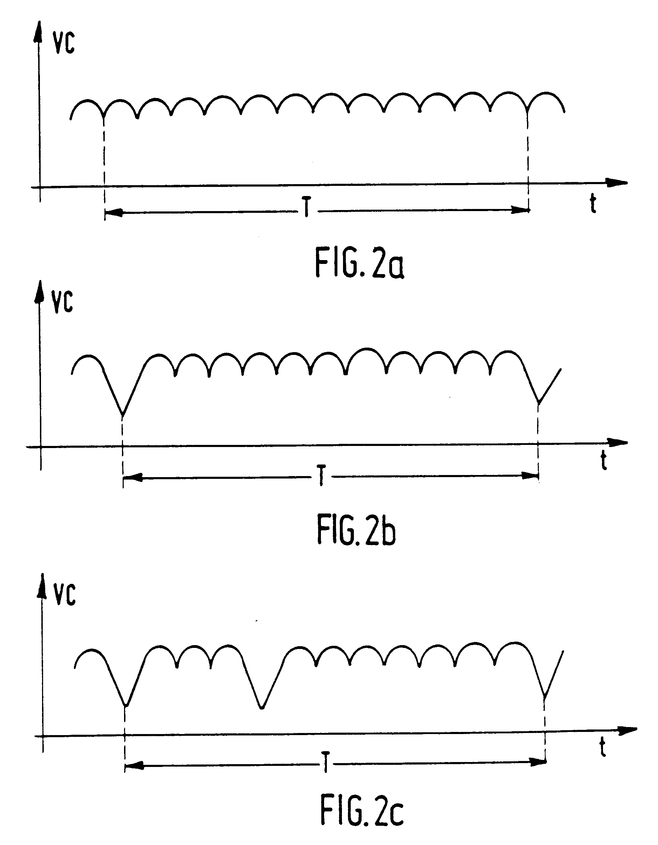

Sur la figure 2a, on a représenté l'allure de la tension redressée VC lorsque les douze diodes 31 à 36 et 31′ à 36′ fonctionnent toutes convenablement. Sur la figure 2a, il apparaît que l'ondulation résiduelle présentée par le tension VC est de période T/12, T étant la période de la tension à redresser, égale ici à 1/400^{ème} de seconde.

Chaque crête de l'ondulation résiduelle correspond à la mise en conduction de chacune des diodes.

Sur la figure 2b, on a représenté l'allure de la tension redressée VC lorsque l'une quelconque, et une seule, des diodes 31 à 36 et 31′ à 36′ se trouve en circuit ouvert. Dans ce cas, la crête de la fig. 2a qui correspondait au passage du courant dans cette diode se trouve remplacée par une pointe descendante. Cette pointe se répète avec la période T.

Sur la figure 2c, on a représenté le cas où deux diodes sont en circuit ouvert. Dans ce cas, il y a deux pointes descendantes à l'intérieur de chaque période T. Si plusieurs diodes étaient en circuit ouvert, il y aurait plusieurs pointes descendantes à l'intérieur de chaque période T. Il est à noter que, si les pointes descendantes peuvent être qualifiées de négatives lorsque l'on se place du point de vue de l'ondulation résiduelle centrée sur la composante continue de la tension VC, elles restent, en valeur absolue, inférieures ou égales à la valeur de cette composante continue, ce qui fait que la tension VC ne change jamais de signe.

Le circuit électronique 4 est, comme cela va maintenant être expliqué, agencé pour détecter le franchissement temporaire, par la tension redressée VC, d'un seuil bas SB, choisi pour être inférieur à la valeur minimale de la tension VC dans le cas de la figure 2a, tout en étant supérieur aux valeurs prises par la tension VC pendant les pointes négatives des figures 2b et 2c.

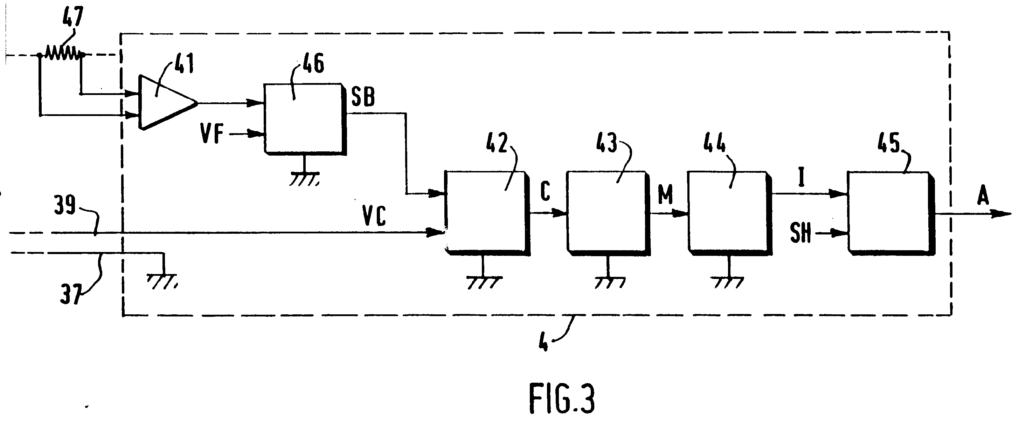

A cet effet, et en référence à la figure 3, le circuit électronique 4 comprend tout d'abord un comparateur d'amplitude 42, dont une première entrée reçoit le signal de la première entrée du circuit 4, c'est-à-dire la tension VC. Le comparateur d'amplitude 42 est pourvu d'une seconde entrée recevant une tension SB représentant le seuil bas dont il a été question, et d'une sortie délivrant un signal C.

Un amplificateur opérationnel différentiel 41 amplifie le signal sur la deuxième entrée du circuit 4, qui est la tension aux bornes de la résistance 47, image du courant consommé par les circuits d'utilisation. La sortie de l'amplificateur 41 est appliquée à la première entrée d'un sommateur 42, dont la deuxième entrée reçoit une tension fixe VF et dont la sortie délivre le signal SB.

Un circuit monostable 43 reçoit, sur son entrée de déclenchement, le signal C, et délivre en sortie un signal M.

Un intégrateur 44 intègre le signal M pour délivrer le signal 1, qui est comparé à une tension SH, représentant un seuil haut, dans un comparateur d'amplitude 45 dont la sortie délivre le signal A.

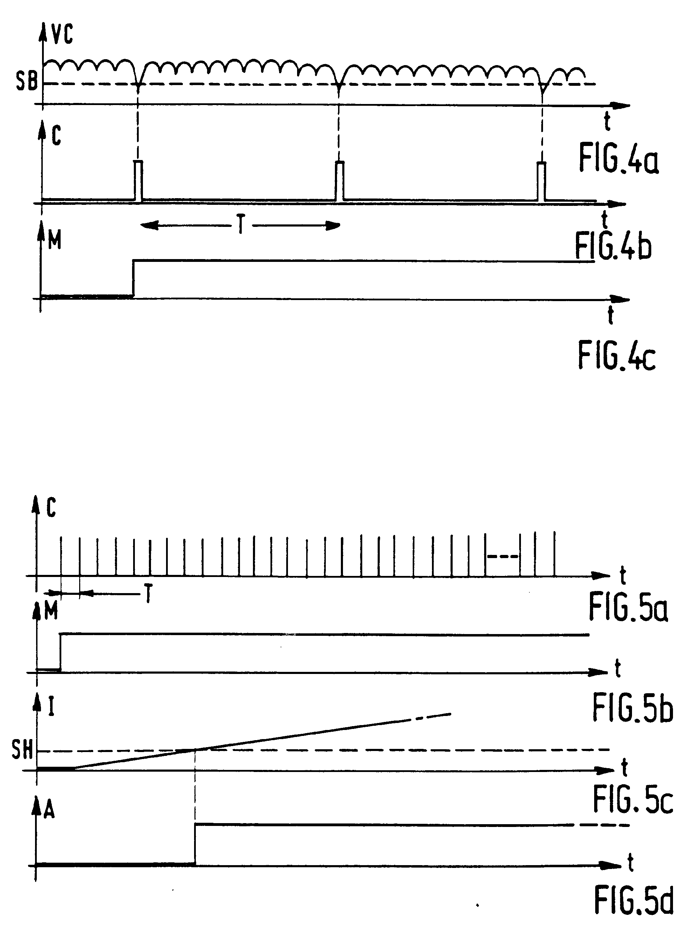

Le fonctionnement du circuit 4 qui vient d'être décrit est le suivant, en référence notamment aux figures 4 et 5.

Sur la figure 4a, on a représenté d'une part l'allure de la tension redressée VC et d'autre part la tension SB de seuil bas. Le franchissement temporaire du seuil bas SB par la tension VC, caractéristique de la mise en circuit ouvert d'au moins une diode, est détecté par le comparateur 42. Le signal C, comme le montrent les figures 4b et 5a, se présente donc comme une suite d'impulsions, se répétant avec une période T, ici égale à 400 Hz, dans le cas où une seule diode est en circuit ouvert.

Les impulsions du signal C déclenchent le circuit monostable 43, dont la constante de temps est supérieure à la période T, ce qui fait que lorsque la présence des pointes descendantes de la tension VC est permanente, le circuit monostable 43 maintient sa sortie M au niveau haut, comme le montrent les figures 4c et 5b. L'intégrateur 44, ayant une constante de temps de plusieurs secondes, temporise le déclenchement de l'alarme, jusqu'à ce que la tension I franchisse le seuil haut SH, comme le montrent les figures 5c et 5d représentant respectivement l'allure de la tension I, et celle de la tension A.

Pour assurer un fonctionnement correct pour toutes les valeurs possibles du courant de sortie, l'amplificateur 41 et le sommateur 46 commandent la valeur du seuil bas SB en réponse à la valeur du courant de sortie, de façon à ce que la valeur du seuil bas diminue quand la valeur du courant augmente, la tension SB étant la somme algébrique de la tension constante, ou fixe, VF et de la tension en sortie de l'amplificateur 42, image du courant fourni à l'utilisation. En effet, la valeur de l'amplitude des pointes descendantes augmente avec le courant de sortie.

Naturellement, la présente invention n'est pas limitée à la description qui vient d'être faite de la forme de réalisation préférée.

C'est ainsi qu'il est possible de disposer, en série avec chacune des diodes 31 à 36 et 31′ à 36′, un transformateur dont le secondaire délivre une image du courant traversant cette diode. A la sortie de chacun des douze transformateurs, on dispose un circuit de surveillance de l'allure du courant, une diode en circuit ouvert étant détectée par le fait que le courant qui la traverse est constamment nul, alors qu'une diode en bon état est traversée par un courant alternatif. Les sorties des douze circuits de surveillance sont reliées à un circuit logique, chargé d'éviter le déclenchement d'une fausse alarme lorsque le courant de sortie est nul, puisqu'à ce moment le courant dans chacune des diodes est nul, même si cette diode est en bon état. Le circuit logique lève l'ambiguité en ne déclenchant pas l'alarme si les douze courants sont nuls, ou si le courant de sortie est lui-même nul.

Une telle forme de réalisation, mettant en oeuvre douze transformateurs, douze circuits de surveillance et un circuit logique de levée d'ambiguité est toutefois plus encombrante, plus lourde, d'un coût relativement plus élevé et moins fiable que la forme de réalisation préférée qui a été décrite.

Naturellement, les applications du dispositif de surveillance de l'invention ne sont limitées ni aux aéronefs, ni au transformateur-redresseur triphasé à secondaire étoile-triangle qui a été décrit à titre d'exemple. L'invention est particulièrement utile dans le cas où le nombre de diodes est important, c'est-à-dire pour tout redresseur polyphasé.

## Revendications

1. Dispositif de surveillance pour redresseur polyphasé, comprenant des moyens de détection (4) de la mise en circuit ouvert d'au moins une des diodes de redressement (31-36, 31′-36′) dont est pourvu ledit redresseur, pour commander une alarme (A) en cas de détection, caractérisé par le fait que lesdits moyens de détection (4) sont connectés aux bornes de sortie du redresseur et détectent le franchissement temporaire d'un seuil bas (SB) par la tension (VC) en sortie dudit redresseur.

2. Dispositif selon la revendication 1, dans lequel il est prévu des moyens de commande (47, 41, 46) de la valeur dudit seuil bas (SB) en réponse à la valeur du courant en sortie dudit redresseur, de façon à ce que la valeur dudit seuil bas (SB) diminue quand la valeur dudit courant augmente.

3. Dispositif selon l'une des revendications 1 ou 2, dans lequel il est prévu un circuit monostable (43), déclenché en réponse audit franchissement temporaire, et dont la constante de temps est supérieure à la période (T) de la tension à redresser par ledit redresseur.

4. Dispositif selon la revendication 3, dans lequel il est prévu des moyens (44) d'intégration de la valeur du signal de sortie (M) dudit circuit monostable (43), et des moyens (45) de comparaison, à un seuil haut (SH), de la valeur du signal en sortie (I) desdits moyens d'intégration (44), qui déclenchent ladite alarme (A) en cas de franchissement dudit seuil haut (SH) par le signal en sortie (I) desdits moyens d'intégration (44).

## Patentansprüche

1. Überwachungseinrichtung für Mehrphasengleichrichter mit Mitteln zur Erfassung (4) der Unterbrechung wenigstens einer der Gleichrichterdioden (31-36, 31′-36′), mit denen der Gleichrichter ausgestattet ist, um einen Alarm (A) im Falle der Erfassung auszulösen, dadurch gekennzeichnet, daß die Mittel zur Erfassung (4) mit den Ausgangsanschlüssen des Gleichrichters verbunden sind und die zeitweilige Überschreitung einer unteren Schwelle (SB) durch die Ausgangsspannung (VC) des Gleichrichters erfassen.

2. Einrichtung nach Anspruch 1, dadurch gekennzeichnet, daß Steuermittel (47, 41, 46) für den Wert der unteren Schwelle (SB) vorhanden sind, ansprechend auf die Stromstärke am Ausgang des Gleichrichters, so daß der Wert der unteren Schwelle (SB) abnimmt, wenn die Stromstärke zunimmt.

3. Einrichtung nach Anspruch 1 oder 2, dadurch gekennzeichnet, daß ein monostabiler Schaltkreis (43) vorgesehen ist, der ansprechend auf das zeitweilige Überschreiten ausgelöst wird, und dessen Zeitkonstante größer ist als die Periode (T) der durch den Gleichrichter gleichzurichtenden Spannung.

4. Einrichtung nach Anspruch 3, dadurch gekennzeichnet, daß Integrationsmittel (44) für den Wert des Ausgangssignals (M) des monostabilen Schaltkreises (43) vorgesehen sind, sowie Mittel (45) zum Vergleich des Ausgangssignals (I) der Integrationsmittel (44) mit einer oberen Schwelle (SH), die den Alarm (A) im Falle des Überschreitens der oberen Schwelle (SH) durch das Ausgangssignal (I) der Integrationsmittel (44) auslösen.

## Claims

1. A monitoring device for a multiphase rectifier, comprising means (4) for detecting the opening of at least one of the rectifier diodes (31-36, 31′-36′) with which the said rectifier is provided, in order to control an alarm (A) in the case of detection, characterised in that the said detection means (4) are connected to the output terminals of the rectifier and detect the temporary crossing of a low threshold (SB) by the voltage (VC) output from the said rectifier.

2. A device according to claim 1, in which control means (47, 41, 46) are provided for the value of the said low threshold (SB) in response to the value of the current output from the said rectifier so that the value of the said low threshold (SB) falls when the value of the said current increases.

3. A device according to one of claims 1 or 2, in which a monostable circuit (43) is provided, triggered in response to the said temporary crossing of the threshold and of which the time constant is greater than the period (T) of the voltage to be rectified by the said rectifier.

4. A device according to claim 3, in which means (44) are provided for integrating the value of the output signal (M) of the said monostable circuit (43), and means (45) are provided for comparison, with a high threshold (SH), of the value of the output signal (I) of the said integration means (44) which trigger the said alarm (A) in the case of the said high threshold (SH) being crossed by the output signal (I) of the said integration means (44).
